# EUROPEAN PATENT APPLICATION

(11) **EP 4 219 168 A1**
(43) Date of publication of application: **02.08.2023**
(21) Application number: 23154409.9
(22) Date of filing: 01.02.2023
(51) Int. Cl.: B41F 23/04, B05D 3/06, B41J 11/00, F21V 29/60, F21V 29/74, F21V 29/83

(54) **LED CURING APPARATUS**

(30) Priority: 01.02.2022 GB 202201298; 20.10.2022 GB 202215540
(71) Applicant: GEW (EC) Limited, Crawley, West Sussex RH10 9QR (GB)
(72) Inventor: RAE, Malcolm, Crawley, RH10 9QR (GB); HICKS, James, Crawley, RH10 9QR (GB); RAE, Robert, Crawley, RH10 9QR (GB)
(74) Representative: Windsor, Louise

(57) **Abstract**

An LED curing apparatus (1) comprising at least one LED radiation source mounted on an LED mount; a housing (3) comprising at least one air inlet (27); at least one finned heat sink (11); and at least one air passage (22) through the housing (2) from the or each air inlet (27) through the or each finned heat sink (11) to at least one air outlet; wherein the housing (3) comprises an inlet cavity (21) below the or each finned heat sink (11) and an outlet cavity (24) above the or each finned heat sink (11) to maintain a higher air pressure below the or each finned heat sink (11) and a lower air pressure above the or each finned heat sink (11).

## Description

The present invention relates to an improved cooling system for an LED curing apparatus for printing and coating applications.

The use of LED (light-emitting diode) arrays for curing in printing and coating applications is becoming increasingly popular as an alternative to traditional mercury arc lamps. However, a limitation to the use of LEDs in existing curing apparatus, which have a standard heat sink and known cooling systems to carry heat away from the LEDs, is that the apparatus must be run at a reduced power to prevent overheating of the LEDs. There is a need to ensure that generated heat is efficiently transferred away from the high density LEDs. The use of LEDs in print curing applications requires high density packing of LEDs on a circuit board, such that a very large amount of heat is generated across a fixed area. It is important that the LEDs do not overheat and become damaged or fail. Effective cooling is also needed to ensure that the curing effect is not sub-optimal; and that the output of the LEDs is not reduced by ineffective cooling.

Air-cooled LED devices for printing and coating applications use multiple axial fans within the lamphead to push air through the apparatus. This requires extra electronic components to be mounted in the lamphead, which increases the complexity of the installation and the required maintenance of the device. The use of multiple axial fans also increases the number of potential points of failure. Such existing air-cooled devices that push air through and along the length of the apparatus have also been found to carry contaminants into and through the device; for example, dust or ink. Furthermore, existing arrangements proposing the use of a single fan do not achieve the required uniformity of cooling along the length of the apparatus. Thus, there remains a significant need to provide an improved cooling system for LED curing apparatus for printing and coating applications. There are also significant environmental benefits in improving the efficiency of the cooling system because this reduces the power that needs to be supplied to cool the lamphead and so the environmental impact of the curing process. Furthermore, the present invention allows for re-use of existing cooling fans and other print curing apparatus from mercury lamp curing systems with the improved LED curing apparatus of the present invention.

The present invention sets out to provide an improved LED curing apparatus, which alleviates the problems described above.

In one aspect, the invention provides an LED curing apparatus comprising: at least one LED radiation source mounted on an LED mount;
a housing comprising at least one air inlet;
at least one finned heat sink;
at least one air passage through the housing from the or each air inlet through the or each finned heat sink to at least one air outlet;
wherein the housing comprises an inlet cavity below the or each finned heat sink and an outlet cavity above the or each finned heat sink to maintain a higher air pressure below the or each finned heat sink and a lower air pressure above the or each finned heat sink.

Preferably, the LED curing apparatus further comprises a source of air and the air pressure in the inlet cavity below the or each finned heat sink is higher than the air pressure in the outlet cavity above the or each finned heat sink.

Preferably, air from an external source enters through the at least one air inlet and enters the or each finned heat sink via the inlet cavity.

Preferably, the source of air is a source of ambient or cooled air.

More preferably, the LED curing apparatus further comprises a source of air and the air pressure in the inlet cavity below the or each finned heat sink is higher than the air pressure in the outlet cavity above the or each finned heat sink to cause the flow of air along the or each air passage through the housing from the or each inlet to the or each air outlet through the or each finned heat sink.

Preferably, the LED curing apparatus further comprises a source of air and the air pressure in the inlet cavity below the or each finned heat sink is higher than the air pressure in the outlet cavity above the or each finned heat sink to cause suction of air along the or each air passage through the housing from the or each inlet to the or each air outlet through the or each finned heat sink.

It is understood that "below" the or each finned heat sink refers to the direction towards the LED-mounting/substrate-facing surface of the LED curing apparatus. It is understood that "above" the or each finned heat sink refers to the direction opposing the LED-mounting/substrate-facing surface of the LED curing apparatus.

Preferably, air is pulled out of the housing through the or each air outlet and pulled into the housing through the or each air inlet.

Preferably, the LED curing apparatus comprises a source of air and the air pressure decreases from the at least one air inlet to the inlet cavity and decreases further from the inlet cavity to the outlet cavity and decreases further again from the outlet cavity to the or each air outlet.

The arrangement of the present invention with an inlet cavity/opening and an outlet cavity/opening and at least one finned heat sink/s is such that air entering the apparatus steps through a series of pressure changes so that air is pulled into the housing through the or each air inlet and pulled out of the housing through the or each air outlet. The pressure differentials as the air passes through the apparatus are maintained regardless of the length of the apparatus to allow uniform cooling along the length of the apparatus regardless of the length.

It has been found that it is advantageous to pull air through the housing because this allows for better control of the hot air exiting the apparatus. The present invention also reduce the noise created by air exiting the apparatus. It also allows existing apparatus on site to be used; e.g., existing fans and ducting from mercury curing apparatus and/or the same cooling apparatus as used for mercury lamp systems. That is, the present invention allows for a user to interchange between mercury and LED curing apparatus using the same outer housing.

Preferably, the housing is cuboidal.

Preferably, the housing comprises an upper air channel between the air inlet and the inlet cavity. More preferably, at least part of the upper air channel is substantially parallel to the outer walls of the housing. Preferably, the width of the upper air channel is between about 3 to about 5mm; more preferably, the width of the upper air channel is about 4mm.

The upper air channel allows for control of the air flow and air pressure of the air entering the LED curing apparatus; particularly it allows for control of the air flow and air pressure into the inlet cavity below the or each finned heat sink.

Preferably, the LED curing apparatus comprises a plurality of LEDs in a linear array.

Preferably, the LED curing apparatus comprises a plurality of finned heat sinks.

The number of finned heat sinks can be modified according to the length of the apparatus and the number of LEDs mounted in a linear array along the apparatus. The present invention allows the air flow, air pressure, cooling effect and so temperature along the length of the apparatus in use to be substantially uniform. Furthermore, the modular system allows for ease of manufacturing of different lengths of lamps from the same components and allows for ease of repair and availability of spare parts to be improved.

Preferably, wherein the air passage comprises at least one restriction below the or each finned heat sink.

More preferably, the restriction below the or each finned heat sink reduces the cross sectional area of the air flow path from the inlet cavity below the or each heat sink to the or finned heat sink.

Preferably, the reduction in the cross sectional area of the air flow path from the inlet cavity below the or each finned heat sink to the or each finned heat sink is by a ratio of between 1:2 to 1:3 (inlet cavity:finned heat sink); more preferably, the reduction in the cross sectional area of the air flow path from the cavity below the or each finned heat sink to the or each finned heat sink is by a ratio of 2:5 (inlet cavity: finned heat sink); most preferably, the reduction in the cross sectional area of the air flow path from the cavity below the or each finned heat sink to the or each finned heat sink is by a ratio of 1:2.3 (inlet cavity: finned heat sink).

Preferably, the cross sectional area of the air flow path from the cavity below the or each finned heat sink to the or each finned heat sink reduces by more than 50%.

The restriction in the air flow path of the present invention between the inlet cavity below the or each finned heat sink and the or each finned heat sink throttles the air flow, and it has been found that the restriction of the air flow into the finned heat sink causes significant turbulence of the air passing into the heatsink, which increases heat transfer from the fins to the surrounding air. This increases the cooling achieved by the finned heat sinks.

Preferably, wherein the air passage comprises at least one restriction proximal to the or each finned heat sink and at least one further restriction proximal to the at least one air inlet.

Preferably, the or each air outlet is at a first end of the apparatus.

Preferably, the or each air outlet is at a first end of the apparatus and the opposing second end of the apparatus is sealed.

Preferably, the or each air inlet is along substantially the entire length of the apparatus. More preferably, the or each air inlet is along the entire length of the upper face of the apparatus.

It is understood that the upper face is the face opposite to the LED mounting face. The LED mounting face is the substrate-facing face of the apparatus, in use.

In the context of the present invention, "restriction" refers to a means to control air flow; for example, a means to control air flow into the or each finned heat sink from the cavity proximal to the LED mount and/or a means to control air flow at the air inlet wherein air is pulled into the apparatus. The present invention is a significant improvement because it has been found that careful control of the pressure differences within the housing optimises air flow and so cooling of the LED curing apparatus. The present invention allows for equal flow rates of air through the finned heat sinks arranged along the length of the LED curing apparatus so that cooling and the temperature of the device is substantially uniform along the length of the device despite the or each air outlet being positioned only at a first end of the apparatus. Uniformity of cooling along the length of the device ensures the optimum curing effect and the performance of the LEDs is not limited by ineffective cooling. The present invention controls air flow to allow for an air outlet/s at only a first end of the apparatus, whilst still ensuring uniform cooling along the entire length of the device. The pressure differential below and above the or each finned heart sink ensures that cooling air passes through the or each finned sink to carry heat away.

Preferably, the LED curing apparatus further comprises at least one source of cool air and at least one fan to move air into the or each air passage.

Optionally, the LED curing apparatus comprises at least one source of air and a plurality of fans.

Preferably, the LED curing apparatus comprises at least one source of air and at least one fan positioned at a distance from the LED curing apparatus.

Preferably, the or each fan pulls air through the apparatus.

Preferably, the outlet cavity has a greater cross-sectional area than the cross sectional area of the adjacent finned heat sink.

More preferably, the LED curing apparatus further comprises ducting wherein the or each fan is connected to the LED curing apparatus by the ducting.

Preferably, the at least one air inlet is at a first end of the apparatus and the opposing second end of the apparatus is sealed.

Preferably, the or each LED radiation source is arranged at the base of the apparatus.

Preferably, the first end of the apparatus is substantially perpendicular to the base of the apparatus.

Preferably, the at least one air inlet comprises an elongate opening.

Preferably, the at least one air inlet comprises an elongate opening in the upper face of the apparatus.

It is understood that in the context of this invention, the "base of the apparatus" is the substrate-facing surface with the or each LED radiation source arranged thereon. The upper face of the apparatus is substantially parallel to and spaced apart from the base of the apparatus.

Preferably, wherein the air pressure below the or each finned heat sink is greater than air pressure above the or each finned heat sink.

Preferably, the pressure difference between the inlet cavity and the outlet cavity exceeds between about 150Pa and 400Pa along the length of the LED curing apparatus; more preferably, the pressure difference between the inlet cavity and the outlet cavity exceeds between about 150Pa and 300Pa along the length of the LED curing apparatus; most preferably, the pressure difference between the inlet cavity and the outlet cavity exceeds about 150Pa along the length of the LED curing apparatus.

Preferably, the air pressure in the inlet cavity proximal to the or each finned heat sink is between about -310Pa and -610Pa relative to atmospheric pressure.

Preferably, the air pressure in the or each outlet cavity is between about -1150Pa and -650Pa relative to atmospheric pressure.

Preferably, the or each finned heat sink comprises at least one air inlet through which air enters from the housing into the finned heat sink.

Preferably, the ambient absolute temperature of air along the length of the LED curing apparatus is substantially uniform.

It is understood that "length" refers to the longest dimension of the LED curing apparatus.

Preferably, the dimensions of the air inlet of the or each finned heat sink restricts the air flow through the inlet.

The air path of the present invention is carefully configured to achieve the desired cooling effect. The air inlet into the or each finned heat sink chokes i.e., restricts the air flow into the finned heat sink. This ensures that the air flow over the or each finned heat sink is evenly distributed. For example, when a plurality of cooling modules are arranged in a linear array, the cooling achieved at each cooling module is substantially uniform.

Preferably, the LED curing apparatus comprises at least one thermal transfer member.

Preferably, the LED curing apparatus comprises at least one heat pipe.

Optionally, the LED curing apparatus comprises at least one metal rod or at least one metal pipe. Preferably, the LED curing apparatus comprises a plurality of heat pipes.

Preferably, the LED curing apparatus comprises a plurality of metal rods or a plurality of metal pipes.

Optionally, the invention provides an LED curing apparatus comprising:
at least one LED radiation source mounted on an LED mount;
a housing comprising at least one air inlet at a first end of the apparatus; at least one finned heat sink; and
at least one air passage within the housing from the air inlet through the or each finned heat sink to at least one air outlet;
wherein the housing comprises a cavity to maintain a higher air pressure proximal to the LED mount.

Optionally, the housing comprises a cavity to maintain a higher air pressure proximal to the LED mount than the air pressure within the or each finned heat sink.

Optionally, the LED curing apparatus further comprises at least one source of cool air and at least one fan to blow air into the or each air passage.

It has been found that blowing air through the device provides a cleaner environment for the very delicate LEDs that are used to cure the substrate. This improves the reliability of the device and reduces the risk of having to replace LEDs.

Blowing air through the housing from the or each air inlet through the or each finned heat sink to the or each air outlet has been shown to uniformly reduce the temperature along the length of the housing. That is, the temperature of the device does not vary substantially along the length of the device. Furthermore, an air source can be positioned remotely from the device and can reduce the risk of contaminants entering the system. This offers a significantly cleaner solution that provides an improved quality of cured substrate and reduces the risk of failure and the maintenance requirements for the apparatus.

In a further aspect, the invention provides a cooling module, which is securable to one or more thermal transfer members for an LED curing apparatus, wherein the cooling module comprises:
a first finned heat sink and a second finned heat sink;
wherein the first finned heat sink is removably securable to the second finned heat sink to provide at least one aperture therebetween and, wherein each of a plurality of fins protrude from the first finned heat sink and from the second finned heat sink and each fin is substantially perpendicular to the length of the or each aperture.

It is understood that "length" refers to the longest dimension of the aperture.

Preferably, the or each thermal transfer member is a heat pipe.

Optionally, the or each thermal transfer member is a metal rod or a metal pipe. Further optionally, the or each thermal transfer member is a copper rod or a copper pipe.

Preferably, the first finned heat sink and the second heat sink are extruded.

Optionally, the first finned heat sink and the second heat sink comprise a plurality of blades. Further optionally, the first finned heat sink and the second heat sink comprise a plurality of skived fins or blades.

Preferably, the at least one aperture is substantially cylindrical.

Preferably, the cooling module comprises a row of apertures. More preferably, a row of substantially cylindrical apertures.

Preferably, the cooling module comprises a row of apertures along its midline, wherein an inner surface of the first finned heat sink is proximal to an inner surface of the second finned heat sink substantially along the midline of the cooling module.

It is understood that in the context of this invention "proximal to" means that the first finned heat sink is close to the second finned heat sink.

It is understood that in the context of this invention the "midline" of the cooling module is the line or plane of the body of the cooling module equidistant from the outer finned surfaces of the first and second finned heat sinks. The outer surfaces are furthest from the length of the heat pipes in use.

Preferably, the cooling module comprises one or more heat pipes; more preferably, the or each heat pipe is substantially cylindrical.

Preferably, the or each heat pipe is substantially in contact with the wall of the aperture into which it is received.

Preferably, the first finned heat sink and the second finned heat sink are secured to the or each heat pipe.

Preferably, the first finned heat sink is spaced apart from the second finned heat sink by the or each heat pipe.

Preferably, the first finned heat sink is spaced apart from the second finned heat sink by the or each heat pipe along the mid-line of the cooling module.

Preferably, the or each thermal transfer member is a metal rod.

Preferably, the or each metal rod is substantially in contact with the wall of the aperture into which it is received.

Preferably, the first finned heat sink and the second finned heat sink are secured to the or each metal rod.

Preferably, the first finned heat sink is spaced apart from the second finned heat sink by the or each metal rod.

Preferably, the first finned heat sink is spaced apart from the second finned heat sink by the or each metal rod along the mid-line of the cooling module.

Preferably, the axis of each cylindrical aperture is positioned equidistant from the outer edge of the first finned heat sink and from the outer edge of the second finned heat sink.

The axis of the or each cylindrical aperture is the segment containing the centre of the two bases of the cylinder.

Preferably, the cooling module is substantially symmetrical about a rotational axis of symmetry positioned along its midline.

It is understood that in the context of this invention, "symmetrical" refers to the shape and configuration of the first finned heat sink being the same as the shape and configuration of the second finned heat sink. That is, in use the first finned heat sink could take the place of the second finned heat sink if it were rotated by 180-degrees.

Preferably, the fins of the first finned heat sink are aligned to be symmetrical with the fins of the second heat sink about the midline of the cooling module.

Preferably, the first and second finned heat sink each comprise an array of fins wherein each fin is equidistant from an adjacent fin.

Preferably, the first finned heat sink is removably secured proximal to the second finned heat sink by at least one locking member, wherein the or each locking member brings the first finned heat sink into locking engagement with the second finned heat sink. More preferably, the first finned heat sink is removably secured proximal to the second finned heat sink by at least two locking members, wherein the or each locking member brings the first finned heat sink into locking engagement with the second finned heat sink.

Preferably, the or each locking member is spaced apart from the or each fin of the first finned heat sink and the or each fin of the second finned heat sink.

Preferably, the first finned heat sink comprises at least one locking tab for interlocking with at least one locking tab on the second finned heat sink.

More preferably, the first finned heat sink comprises at least two locking tabs for interlocking with at least two locking tabs on the second finned heat sink.

The present invention ensures that the force exerted on the thermal transfer member, such as a heat pipe/s or metal rod/s, by the first finned heat sink is equal to the force exerted on the thermal transfer member, such as a heat pipe/s or metal rod/s by the second finned heat sink.

It is understood that "interlocking" refers to component parts that, in use, mechanically connect and fit together so that movement of the connected parts is constrained.

Preferably, the or each locking tab is L-shaped or U shaped.

Preferably, movement of the first finned heat sink away from the second finned heat sink moves the or each locking tab of the second finned heat sink into an interlocking configuration.

Preferably, when the or each locking tab of the first finned heat sink and the or each locking tab of the second finned heat sink are interlocked, further movement of the first finned heat sink away from the second finned heat sink is restricted.

Preferably, when the or each locking tab of the first finned heat sink and the or each locking tab of the second finned heat sink are interlocked, the first finned heat sink is spaced apart from the second finned heat sink.

More preferably, when the or each locking tab of the first finned heat sink and the or each locking tab of the second finned heat sink are interlocked, the first finned heat sink is spaced apart from the second finned heat sink by about 2mm.

Preferably, the first finned heat sink and the second finned heat sink are secured to the or each thermal transfer member, such as a heat pipe/s or a metal rod/s, with a gap between each thermal transfer member, such as a heat pipe or metal rod, and the substantially cylindrical aperture into which it is received of less than or equal to about 1mm.

Preferably, the or each locking member comprises a tension pin or a resilient pin or a spring pin insertable between the at least one locking tab of the first finned heat sink and the at least one locking tab of the second finned heat sink.

Optionally, the or each locking member is a screw; preferably, a threaded screw

Preferably, insertion of the or each locking member between the at least one locking tab of the first finned heat sink and the at least one locking tab of the second finned heat sink prevents movement of the first finned heat sink away from the second finned heat sink.

Preferably, insertion of the or each locking member between the at least one locking tab of the first finned heat sink and the at least one locking tab of the second finned heat sink locks the first finned heat sink in position spaced apart from the second finned heat sink.

The locking member of the present invention allows the cooling module to be locked in position without the use of additional tooling or fixings.

Preferably, the or each locking member is inserted such that its length is parallel to the length of the or each aperture.

Preferably, each locking member is insertable between the at least one locking tab of the first finned heat sink and the at least one locking tab of the second finned heat sink to lock the locking tabs together in a locked configuration.

Preferably, the locking member further comprises at least one stop at a first end.

Preferably, the locking member is tapered at a second end.

Preferably, the locking tabs are immovable in a locked configuration.

Preferably, the first finned heat sink and the second finned heat sink are aluminium. Optionally, the first finned heat sink and the second finned heat sink are copper.

In a further aspect the invention provides an LED curing apparatus comprising:
an LED array comprising a plurality of LEDs mounted on an LED heat sink;
at least one cooling module as previously described secured around one or more thermal transfer member, wherein the thermal transfer member is a heat pipe and wherein the evaporator section of the or each heat pipe is proximal to the LED array and the condenser section of the or each heat pipe is held substantially within the at least one cooling module.

Preferably, the or each thermal transfer member is a heat pipe.

Preferably, the LED curing apparatus is for printing and coating applications.

Preferably, the at least one cooling module is locked to the or each heat pipe by insertion of at least one locking member; more preferably, the at least one cooling module is locked to the or each heat pipe by insertion of at least two locking members.

The use of at least two locking members has been found to be advantageous in preventing any twisting of the first and second finned heat sinks within the cooling module.

Preferably, wherein the or each locking member is inserted into the surface of the or each cooling module that is furthest from the LED array.

Preferably, the LED curing apparatus is air cooled and comprises at least one inlet through which cool air enters the LED curing apparatus and at least one outlet through which heated air leaves the LED curing apparatus.

Preferably, the LED curing apparatus comprises a plurality of cooling modules along the length of the LED curing apparatus.

The "length" is understood to refer to the greatest of the three dimensions of the LED curing apparatus.

In a further aspect, the present invention provides a method of installation of at least one cooling module into an LED curing apparatus, comprising a plurality of thermal transfer members:
removably securing a first finned heat sink to a second finned heat sink to provide at least one aperture therebetween, wherein a thermal transfer member is held within each of the at least one apertures;
adjusting the position of the or each thermal transfer member;
locking the first finned heat sink to the second finned heat sink by insertion of at least one locking member to form a cooling module;
attaching the cooling module to an LED heat sink supporting an LED array.

Preferably, the or each thermal transfer member is a heat pipe.

Preferably, the or each thermal transfer member is a metal rod.

Preferably, the at least one cooling module is a cooling module as described herein.

Preferably, the or each locking member is an elongate locking member; more preferably, the or each locking member is an elongate pin that is inserted such that its length is parallel to the length of the or each aperture.

Optionally, the or each locking member is a screw; preferably a threaded screw.

Preferably, the method of installation further comprises applying a thermal transfer material to the at least one aperture.

More preferably, the thermal transfer material is a thermal transfer paste.

In a further aspect, the present invention provides an LED curing apparatus cooling system comprising at least one LED mount for mounting a plurality of LEDs; at least one bore in the LED mount;
at least one thermal transfer member, wherein the or each thermal transfer member is removably connected to a bore; and
wherein each thermal transfer member comprises a collar having an outer surface to mate with an inner surface of a bore.

Preferably, the at least one thermal transfer member is a metal rod.

Preferably, the collar is attached to a first end of the metal rod.

Preferably, the collar and the metal rod and formed as a single piece.

Preferably, the at least one thermal transfer member is a heat pipe comprising an evaporator section and a condenser section.

Preferably, the collar is attached to the evaporator section of the heat pipe.

Preferably, the outer surface of the or each collar is shaped to mate with a shaped inner surface of a respective bore.

Preferably, the outer surface of the or each collar comprises a threaded portion to mate with a threaded inner surface of a respective bore.

Preferably, the threaded portion is a substantial part of the or each collar.

Preferably, the or each collar is a connecting band; more preferably, an annular band.

Optionally, the or each collar is cylindrical having a base at a first end and an opening at an opposing second end.

Preferably, the or each thermal transfer member is soldered to the collar.

Preferably, the or each metal rod is soldered to the collar.

Preferably, the or each heat pipe is soldered to the collar.

Preferably, the LED mount comprises a thermal transfer material between the or each thermal transfer member and the bore.

Preferably, the LED mount comprises a thermal transfer material between the or each metal rod and the bore.

Preferably, the thermal transfer material is a high performance thermal interface material. More preferably, the thermal transfer material has a thermal conductivity greater than about 5W/mK.

Preferably, the LED mount comprises a thermal transfer material between the or each heat pipe and the bore.

Preferably, the thermal transfer material is a ceramic paste.

Preferably, the thermal transfer material is provided between the collar and the bore to which the collar is removably connected.

Preferably, the cooling system comprises one or more LEDs mounted on the LED mount.

Preferably, the or each thermal transfer member is positioned adjacent to the LEDs.

Preferably, the or each metal rod is positioned adjacent to the LEDs.

Preferably, the or each heat pipe is positioned adjacent to the LEDs.

Preferably, the LED mount comprises aluminium.

Preferably, the LED mount comprises an aluminium block.

Preferably, the or each collar comprises copper.

Preferably, the or each collar comprises a threaded portion and a non-threaded portion. Preferably, the or each collar comprises a threaded portion and a smooth portion.

Preferably, the or each bore is substantially cylindrical.

In a further aspect, the present invention provides a cooling module comprising the cooling system for an LED print curing apparatus as previously described, wherein the or each thermal transfer member is also connected to at least one air-cooled heat sink.

Preferably, the thermal transfer member is a metal rod.

Preferably, the thermal transfer member is a heat pipe.

Preferably, the cooling module comprises at least one finned heat sink.

According to another aspect of the present invention, there is provided a print curing apparatus comprising a cooling system as described herein.

Preferably, the print curing apparatus is a UV curing apparatus.

Within this specification, the term "substantially" is understood to refer to a variation of less than about 20%; preferably, less than about 10%; preferably, less than about 5%; preferably, less than about 2%.

For the purposes of clarity and a concise description, features are described herein as part of the same or separate embodiments; however, it will be appreciated that the scope of the invention may include embodiments having combinations of all or some of the features described.

The invention will now be described by way of example with reference to the accompanying drawings, in which: -
Figure 1 shows a cross section through the LED curing apparatus of the present invention and the air flow path therethrough for a preferred embodiment wherein air is pulled through the LED curing apparatus;
Figure 2 shows a perspective external view of the LED curing apparatus of Figure 1 showing the direction of air flow through the apparatus;
Figure 3 shows a cross section through the LED curing apparatus of the present invention and the air flow path therethrough for an embodiment wherein air is blown through the LED curing apparatus;
Figure 4 shows a perspective external view of the LED curing apparatus of Figure 3 showing the direction of air flow through the apparatus;
Figure 5a shows a perspective view of a cooling module for an LED print curing apparatus;
Figure 5b shows a perspective view of an alternative embodiment of the cooling module for an LED print curing apparatus shown in Figure 5a;
Figure 6 shows a side view of a cooling module for an LED print curing apparatus;
Figure 7 shows a view from above of a first finned heat sink;
Figure 8a shows a view from above of a first finned heat sink interlocking with a second finned heat sink (heat pipes not shown) in a maintenance or assembly configuration;
Figure 8b shows a view from above of a first finned heat sink locked to a second finned heat sink (heat pipes not shown) in a use configuration;

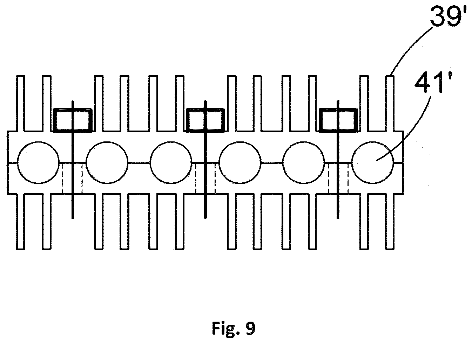

Figure 9 shows a view from above of a first finned heat sink locked to a second finned heat sink (heat pipes not shown) in a use configuration in an alternative to the present invention;
Figure 10 is a cross-sectional view through a cooling system for an LED print curing apparatus;
Figure 11a is a perspective view of a heat pipe and collar, as shown in Figure 10;
Figure 11b is a perspective view of an alternative embodiment of the thermal transfer member of Figure 11a, wherein the thermal transfer member is a metal rod with a collar;
Figure 12 is a cross-sectional view of the heat pipe and collar shown in Figure 10.

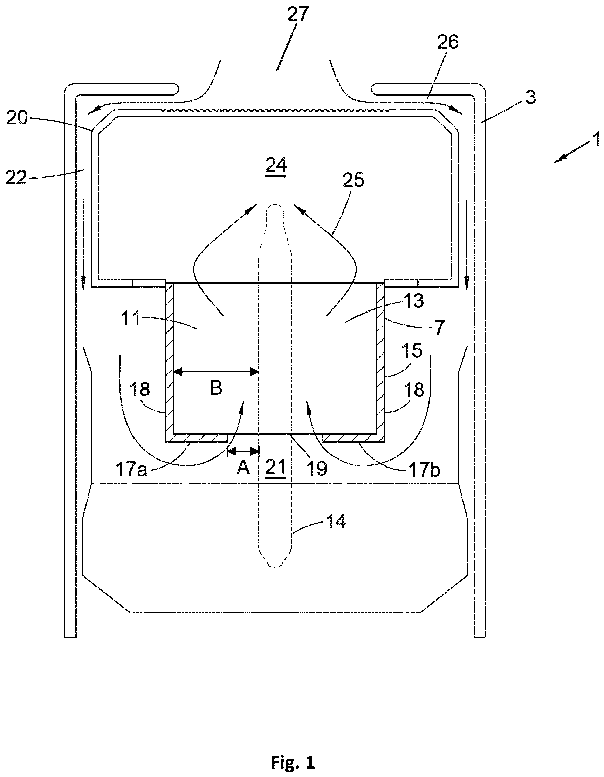

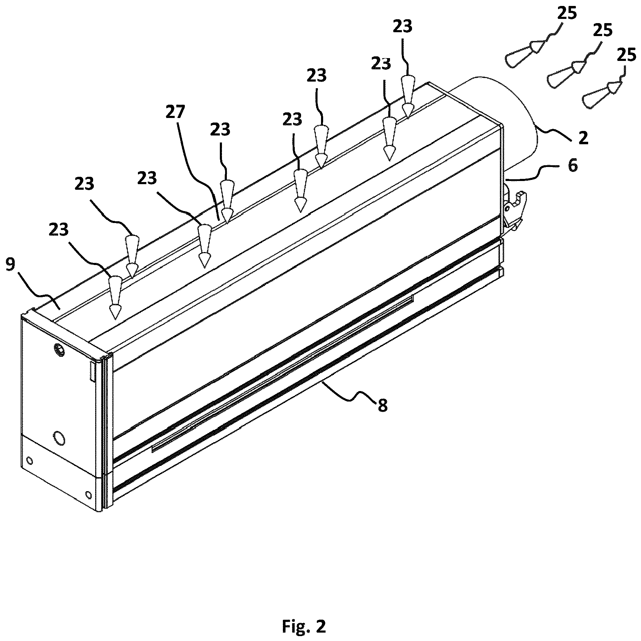

Referring to Figures 1 and 2, an LED curing apparatus 1 is shown comprising a housing 3. The housing 3 comprises an outer casing wherein LEDs (not shown) are mounted at the base 8 of the housing 3 and an air inlet 27 is positioned in an upper face 9 of the housing 3. The air inlet 27 is an elongate opening along substantially the entire length of the upper face of the apparatus. The base of the LED curing apparatus 1 is the substrate-facing surface with the or each LED radiation source arranged thereon. In a preferred embodiment the LED radiation source is a UV radiation source. In alternative embodiments, the LED radiation source is an infra-red radiation source. The upper face of the apparatus 1 is substantially parallel to and spaced apart from the base of the apparatus 1. An air outlet 2 is positioned at a first end 6 of the apparatus 1, wherein the first end 6 is perpendicular to and between the base 8 and the upper face 9 of the apparatus 1. The air outlet 2 is attached to ducting connected to a source of ambient or cooled air.

The LED curing apparatus 1 comprises a plurality of LEDs (not shown) mounted to an LED mount. The inner walls of the housing 3 and the cavities formed therein are shaped to control air pressure and air flow through the LED curing apparatus 1. The housing 3 is substantially cuboidal comprising outer walls 3 and inner walls 20 to which further components are mounted. The shape of the inner walls of the housing 3 controls air pressure and so air flow through the device.

Referring to Figure 1, an inner wall of the housing 20 defines an upper air channel 22 through which air from the air inlet 27 passes into the curing apparatus 1. The upper air channel 22 is parallel to the outer walls 3 of the housing. Preferably, the width of the upper air channel 22 is about 4mm. The upper air channel 22 increases in width to about 10mm and passes from the air inlet 27 to an inlet cavity or void 21.

A plurality of thermal transfer members, shown in Figures 1 and 2 to be heat pipes 14, are mounted along the length of the LED curing apparatus 1. In alternative embodiments, an alternative thermal transfer member is used; for example, as shown in Figure 1a, the thermal transfer member is a metal rod . In the embodiment shown in Figure 1, each heat pipe 14 is held securely within a cooling module 7, ensuring optimum thermal contact between the heat pipe 14 and a substantially cylindrical recess into which each heat pipe is received. The or each heat pipe 14 passes through the inlet cavity or void 21 of the housing 3. The cooling module 7 comprises a first finned heat sink 11 and a second finned heat sink 13. The first finned heat sink 11 is substantially symmetrical to the second finned heat sink 13 about a central axis or midline. Each finned heat sink 11, 13 is shaped to maximise heat transfer away from the heat sink 11, 13 through a plurality of fins (not shown), which are substantially cuboidal. In alternative embodiments, it is understood that equivalent heat sinks could be used. For example, an arrangement of pins or blades could be used, including a skived heat sink. It is also envisaged that alternative configurations of the present invention include finned heat sinks in alternative positions to carry heat away from the thermal transfer members, which are either heat pipes or metal rods.

The inner walls of the housing 3 define a main cavity or void 21 below the or each finned heat sink 11, 13 and a second cavity or outlet void 24 above the or each finned heat sink 11, 13 through which heated air 25 exits the LED curing apparatus 1. For example, the cross-sectional area of the air path through the outlet void 24 is about 1.2 times greater than the cross-sectional area of the air path through the inlet void 21.

The first finned heat sink 11 and the second finned heat sink 13 are removably held within the housing 3 by a shaped extrusion 15 comprising a base 17a, 17b and two upstanding walls 18. The base 17a, 17b and upstanding walls 18 are formed of a shaped extrusion, wherein each upstanding wall 18 is substantially perpendicular to the base 17a, 17b and held within the outer walls of the housing 3. The base 17 comprises a first base member 17a and a second base member 17b, which are substantially parallel to the LED mount. The first and second base members 17a, 17b partially cover the base of the respective finned heat sink 11, 13. The first finned heat sink 11 is housed above the first base member 17a and the second finned heat sink 13 is housed above the second base member 17b. The base members 17a, 17b are spaced apart from each other to form a restriction in the air flow through a gap therebetween to provide an air inlet 19 into the finned heat sinks 11, 13 through which air is pulled.

Referring to Figures 1 and 2, air 27 is pulled into the apparatus by a source of air connected by ducting to the outlet 2. Typically, the air pressure at the outlet ducting is about -2050Pa relative to ambient pressure and the pressure of air drawn into the air inlet 27 is between about -350Pa to - 500Pa relative to ambient pressure. The air pressure is higher at the inlet 27 to the apparatus to create suction so that air is pulled through the apparatus 1 from the inlet 27 to the outlet 2. The air 26 flows from the inlet 27 around an air passage 22 along the inner walls of the housing 3 and enters the open, inlet cavity/void 21 below the or each finned heat sink 11, 13 to expand such that air pressure decreases to about -500Pa to -450Pa relative to ambient pressure. The air from the open cavity/void 21 adjacent to the LED mount then flows, i.e., is pulled into the finned heat sinks 11, 13 to carry heat away from the heat sinks 11, 13.

The air inlet 19 into the finned heat sinks 11, 13 controls i.e., throttles the air flow entering the finned heat sinks 11, 13 from the inlet cavity 21 of the housing 3 to create a turbulent flow of air through the finned heat sinks 11, 13. When the heated air 25 is carried out of the finned heat sinks 11, 13 it expands into the second cavity or outlet void 24 so that pressure decreases again.

The restriction 17a, 17b proximal to the or each finned heat sink 11, 13 reduces the cross sectional area of the air flow path from the open inlet cavity 21 below the finned heat sink 11, 13. The reduction in the cross sectional area of the air flow path from the inlet cavity 21 to the finned heat sinks 11, 13 is by a ratio of about 1:2.3 (inlet cavity:finned heat sink). The reduction in the cross-sectional area of the air flow path from the cavity 21 below the heat sinks 11, 13 to the or each finned heat sink 11, 13 reduces by more than 50%. In an example apparatus 1, the air inlet 19 between the outer wall of the heat pipe 14 and the restriction 17a, 17b is about 8.5mm (A) so that the open area per heat sink is about 410mm². Air enters the finned heat sinks 11, 13 through the air inlet 19 and passes across the fins of the heat sinks 11, 13, wherein the distance (B) along, i.e., the length of each fin from the outer wall of the heat pipe 14, is about 19.5mm. When air flows into the heat sinks 11, 13, the restriction of the air flow by the first and second base members 17a, 17b causes significant turbulence of the air passing into the finned heatsinks 11, 13, which increases heat transfer from the fins to the surrounding air. This increases the cooling achieved by the finned heat sinks 11, 13.

The size and shape of the housing 3, the air inlet 27, the air passage 22, the cavity 21, the base supports 17a, 17b and the second cavity/outlet void 24 are carefully configured to decrease relative air pressure moving through the apparatus 1 and maximise cooling of the finned heat sinks 11, 13. The configuration of the present invention ensures that air flows through the apparatus 1 to carry heat away from the thermal transfer members 14, for example heat pipes 14 or metal rods (not shown) and ensures that cooling is substantially uniform along the length of the device 1. The air in the inlet cavity 21 below the finned heat sinks 11, 13 is at a higher pressure than the air in the outlet cavity 24 above the finned heat sinks 11, 13. The air pressure decreases when the air moves out of the finned heat sinks 11, 13 to the outlet cavity 24.

The air pressure outside the apparatus 1 at the air inlet 27 through which air is pulled into the apparatus 1 is about +101kPa. The air pressure decreases when the air reaches the open sections/cavities 21, 24 into which it expands. The air pressure in the inlet cavity 21 is about -600Pa relative to ambient pressure and the air pressure of the heated air 25 exiting the finned heat sinks 11, 13 that is pulled towards the air outlet 2 is about -1150Pa relative to ambient pressure.

The present invention can be configured for any length of apparatus - i.e., according to the required application. The ratios of the air path sections as air flows from the air inlet 27 to the air outlet 2 is controlled to achieve the required air flow and so uniform cooling along the length of the apparatus 1.

Examples of the cross-sectional areas of the air flow passage though each section of the apparatus 1 are set out in Table 1 below for an apparatus having a 30cm length:

**[Table 1]**

| Position | 30cm length apparatus cross sectional area of the air flow passage (mm²) |
|---|---|
| Air inlet (27) | 1964 |
| Air inlet into the finned heat sinks (19) | 3280 |
| Outlet cavity (24) | 3910 |
| Outlet ducting | 6718 |

Referring to Figure 2, in a preferred embodiment of the present invention, air 23 is pulled into the air inlet 27, which is along the length of the housing 3, from a single fan (not shown) at the air outlet 2 at a first end 6 at the rear of the housing 3. The fan can be connected to the housing 3 by ducting and the fan is positioned remotely from the apparatus 1. Referring to Figure 1, air 26 is pulled through the housing 3 and enters the cooling module 7 through the air inlet 19 between the first base member 17a and the second base member 17b. The air inlet 19 effectively controls the air flow entering the cooling module 7. The air inlet/gap 19 through which air enters the finned heat sinks 11, 13 chokes - i.e., restricts and controls the air flow into the finned heat sinks 11, 13. The air then passes along the plurality of fins and through the first and second finned heat sinks 11, 13 adjacent to the thermal transfer members 14, for example, heat pipes 14 or metal rods. The heated air 25 is pulled out of the housing 3 to the outlet cavity 24 and to the outlet 2 to exit and so cool the LED curing apparatus 1.

With reference to Figure 1, the uniformity of pressure, air flow and so cooling along the length of the apparatus 1 was measured by positioning sensors at fixed points (Position 1 - air inlet channel 22; Position 2 - air channel into open cavity 21 ; Position 3 - outlet cavity 24). It can be seen from the results shown in Table 2 below that the pressure measurements are substantially uniform along the length of the apparatus:

**[Table 2]**

| Gauge Pressure (Pa) - relative to ambient pressure | | | | |
|---|---|---|---|---|
| Measurement Point | Position along the length of the apparatus (mm) | | | |
| | 116.25 | 192.75 | 269.25 | 345.75 |
| 1 | -357 | -377 | -473 | -440 |
| 2 | -650 | -783 | -757 | -823 |
| 3 | -483 | -470 | -473 | -447 |

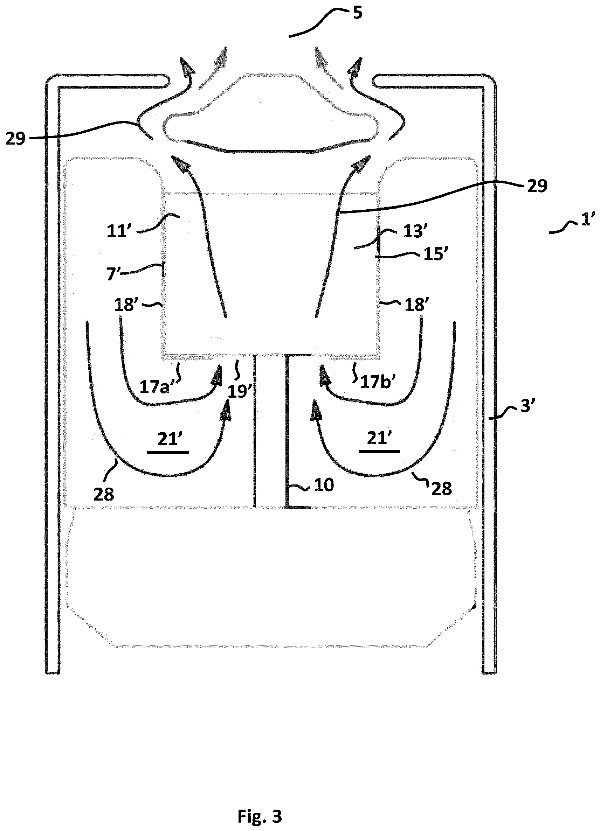

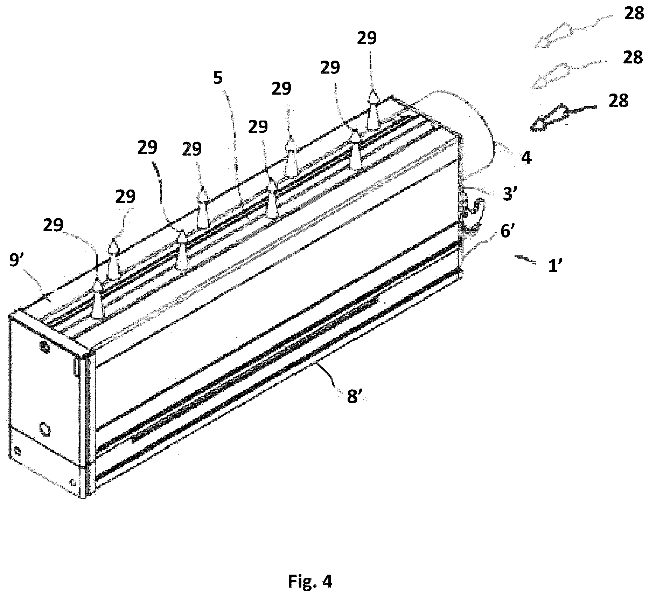

Referring to Figures 3 and 4, an LED curing apparatus 1' of an alternative embodiment is shown, where air is blown (pushed) through the housing from an air inlet 4 to an air outlet 5 . The LED curing apparatus 1' is shown comprising a housing 3'. The housing 3' comprises an outer casing wherein LEDs (not shown) are mounted at the base of the housing 3' and an air outlet 4 is positioned in an upper face of the housing 3. The air outlet 4 is an elongate opening along substantially the entire length of the upper face of the apparatus. The base 8' of the apparatus is the substrate-facing surface with the or each LED radiation source arranged thereon. The upper face 9' of the apparatus is substantially parallel to and spaced apart from the base of the apparatus. An air inlet 4 is positioned at a first end 6' of the apparatus, which is is perpendicular to and between the base 8' and the upper face 9' of the apparatus 1.

The LED curing apparatus 1' comprises a plurality of LEDs (not shown) mounted to an LED mount. The walls of the housing 3' are shaped to control air flow through the LED curing apparatus 1'. The housing 3' is substantially cuboidal comprising outer walls and inner walls to which further components are mounted. The outer walls define a main cavity or void 21' adjacent to the LED mount.

A plurality of thermal transfer members; for example, heat pipes are mounted along the length of the LED curing apparatus 1'. In alternative embodiments, an alternative heat transfer member is used, such as a metal rod. In the embodiment shown in Figure 1, each heat pipe is held securely within a cooling module 7', ensuring optimum thermal contact between the heat pipe and a substantially cylindrical recess 10 into which each heat pipe is received. The heat pipe is positioned within the main cavity or void 21' of the housing 3'. The cooling module 7' comprises a first finned heat sink 11' and a second finned heat sink 13'. The first finned heat sink 11' is substantially symmetrical to the second finned heat sink 13' about a central axis or midline. Each finned heat sink 11', 13' is an aluminium extrusion and is shaped to maximise heat transfer away from the heat sink 11', 13' through a plurality of fins (not shown), which are substantially cuboidal. In alternative embodiments, it is understood that equivalent heat sinks to the extruded aluminium heat sink could be used. For example, an arrangement of pins or blades could be used, including a skived heat sink.

The first finned heat sink 11' and the second finned heat sink 13' are removably supported within the housing 3' by a shaped extrusion 15' comprising a base 17a', 17b' and two upstanding walls 18'. The base 17a', 17b' and upstanding walls 18' are formed of a shaped extrusion, wherein each upstanding wall 18' is substantially perpendicular to the base 17a', 17b' and held within the outer walls of the housing 3'. The base 17a', 17b' comprises a first base member 17a' and a second base member 17b', which are substantially parallel to the LED mount. The base fin components 17a', 17b' partially cover the base of the respective finned heat sink 11', 13'. The first finned heat sink 11' rests on the first base member17a' and the second finned heat sink 13' rests on the second base member 17b'. The first base member 17a' and the second base member 17b' are spaced apart from each other with a gap therebetween to provide an air inlet 19' into the finned heat sinks 11', 13'. The air inlet 19' controls i.e., throttles the air flow entering the finned heat sinks 11', 13' from the main cavity 21' of the housing 3'. The size and shape of the housing 3', the cavity 21' and the base supports 17a', 17b' are carefully configured to maximise cooling of the LED mount and ensure that pressure/air flow and cooling is substantially uniform along the length of the device 1. A greater pressure is maintained outside of the cooling module 7' and a lower pressure is maintained inside the cooling module 7'.

The reduction of air pressure is effectively stepped down from the main cavity 21' to the finned heat sinks 11', 13' to the air outlet 5, wherein the air pressure relative to that at the air inlet 4 is about 100% in the main cavity 21'; is no greater than about 85% in the finned heat sinks and is further reduced at the air outlet 5.

Referring to Figure 4, in an embodiment of the present invention, air 28 is blown into and along the length of the housing 3' from a single fan (not shown) into the air inlet 4 at a first end 6' (rear) of the housing 3'. The fan can be connected to the housing 3' by ducting and the fan is positioned remotely from the apparatus 1'. The air 28 enters the cooling module 7' through the air inlet 19' between the first support 17a' and the second support 17b'. The air inlet 19' effectively controls the air flow entering the cooling module 7'. The air inlet/gap 19' through which air enters the finned heat sinks 11', 13' chokes - i.e., restricts and controls the air flow into the finned heat sinks 11', 13'. The air then passes along the plurality of fins and through the first and second finned heat sinks 11', 13' adjacent to the condenser section of the heat pipe . The heated air 29 rises upwards through the cooling module 7' to the outlet 5 to leave the housing 3'.

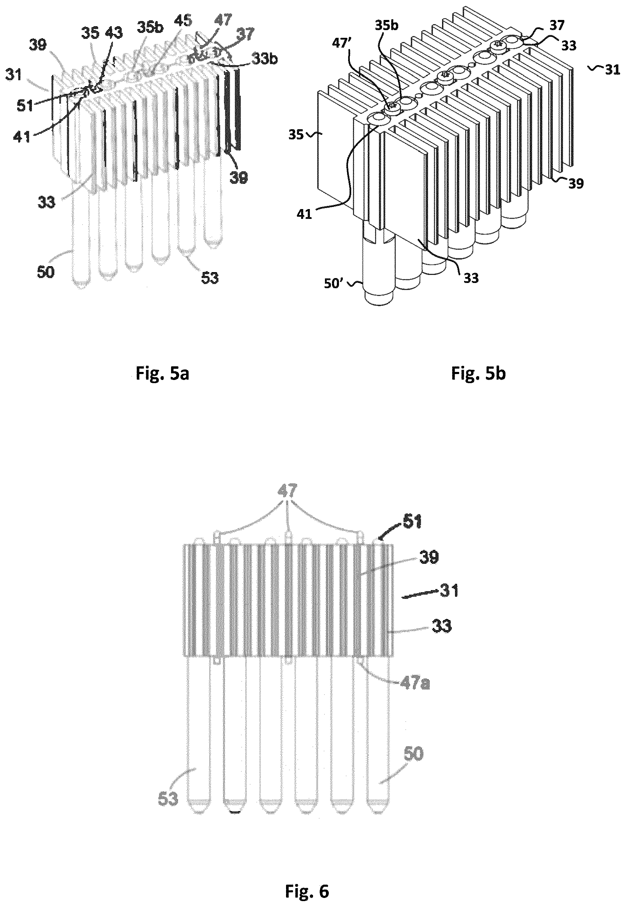

Referring to Figure 5a, Figure 5b, Figure 6 and Figure 7, a cooling module 31 is shown and comprises a first finned heat sink 33 and a second finned heat sink 35. The first finned heat sink 33 is substantially symmetrical to the second finned heat sink 35 about a central axis 37 or midline where the internal surface 33a of the first heat finned sink 33 is proximal to and spaced apart from the internal surface of the second heat finned sink 35. Each finned heat sink 33, 35 is an aluminium extrusion and is shaped to maximise heat transfer away from the heat sink 33, 35 through a plurality of fins 39, which are substantially cuboidal, and each fin protrudes perpendicular to the central axis 37. The plurality of fins 39 are equally spaced from each other so that each fin 39 is spaced from the adjacent fin 39 by a uniform distance. For example, each fin 39 has a width of about between about 1.5mm and 5mm and is spaced from the adjacent fin 39. In a preferred embodiment, the fin 39 has a width of about 1.5mm at its tip with a width increasing towards the midline of the fin with a pitch of 3.5mm.

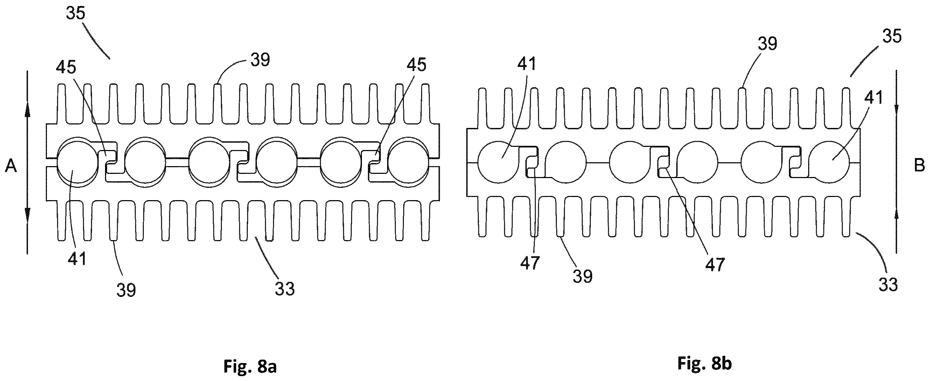

Referring to Figure 5a and Figure 8, the internal surface 33a of the first finned heat sink 33 comprises a series of semi-cylindrical recesses 33b. The internal surface (not shown) of the second finned heat sink 35 also comprises a series of semi-cylindrical recesses 35b and is symmetrical about the central axis 37 where the internal surface 33a of the first finned heat sink 33 is proximal to the internal surface 35a of the second finned heat sink 35. That is, each of the recesses 33b, 35b have the shape of a longitudinal half of a cylinder. As shown in Figure 5, when the first finned heat sink 33 is removably secured to the second finned heat sink 35 the internal face of the first heat sink 33a is spaced apart from the internal face of the second heat sink 35a so that a plurality of substantially cylindrical recesses 41 are formed therebetween.

Referring to Figures 5a, and 6, in a use configuration, the cooling module 31 is secured to a plurality of heat pipes 50.

In alternative embodiments, as shown in Figure 5b, the cooling module 31 is secured to a plurality of thermal transfer members; for example, a metal rod 50' or a metal pipe, such as a copper rod or a copper pipe. The semi-cylindrical recesses 33b, 35b are substantially the same radius as the outer radius of the metal rod 50'. For example, each metal rod 50' has a radius of about 4mm and the cylindrical aperture formed by the semi-cylindrical recesses 33b, 35b have a radius of about 4mm. This ensures that each metal rod 50' is firmly held in place and that the heat transfer is as efficient as possible from each metal rod 50' to the surrounding finned heat sink 33, 35. This maximises the heat transfer away from each metal rod 50' to the fins 39 of each heat sink 33, 35.

Referring to Figure 5a, a heat pipe 50 is received in each of the cylindrical recesses 41. Each heat pipe 50 is held securely within the cooling module 31 to ensure optimum thermal contact between the condenser section of the heat pipe 50 and the cylindrical recess 41 into which the heat pipe is received. The heat pipes 50 secure the first and second finned heat sinks 33, 35 of the cooling module 31 in a tight clamping arrangement. The semi-cylindrical recesses 33b, 35b are substantially the same radius as the outer radius of the heat pipe 50. For example, each heat pipe has a radius of about 4mm and the cylindrical aperture formed by the semi-cylindrical recesses 33b, 35b have a radius of about 4mm. This ensures that each heat pipe 50 is firmly held in place and that the heat transfer is as efficient as possible from each heat pipe 50 to the surrounding finned heat sink 33, 35. This maximises the heat transfer away from each heat pipe 50 to the fins 39 of each heat sink 33, 35.

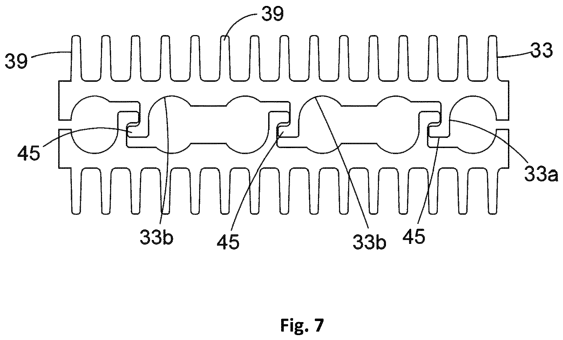

Referring to Figures 7, 8a and 8b. Each finned heat sink 33, 35 comprises an interlocking tab 45. In the embodiment shown in Figure 7, the interlocking tab 45 is substantially L-shaped.

Referring to Figure 8a, in a maintenance configuration, each of the plurality of thermal transfer member, such as heat pipes or metal rods (not shown) are located and held within a cylindrical recesses 41 between the first finned heat sink 33 and the second finned heat sink 35. The tab 45 of the first finned heat sink 33 interlocks with the tab 45 of the second heat sink 35 so that the cooling module 31 is held around the thermal transfer member s (metal rods or heat pipes) but can be adjusted to allow for ease of insertion of multiple thermal transfer members/heat pipes into the cooling module. The interlocking tabs 45 stay linked whilst allowing partial movement of the first finned heat sink 33 and the second finned heat sink 35 around the heat pipes. In this maintenance configuration there is a small gap between the tab 45 of the first finned heat sink 33 that is interlocked to abut with the tab 45 of the second heat sink 35.

For installation of the cooling module, the thermal transfer member, such as heat pipes 50 or metal rods 50' are first fitted to an LED heat sink on which LEDs are mounted. A carefully measured dose of heat transfer paste is applied to the semi-cylindrical recesses 33b, 35b of both the first finned heat sink 33 and the second finned heat sink 35. The first finned heat sink 33 and the second finned heat sink 35 are then interlocked as far as the interlocking tabs 45 allow. The interlocked finned heat sinks 33, 35 are then precisely lowered over and around the thermal transfer member, such as heat pipes or metal rods. The first finned heat sink 33 is spaced apart from the second finned heat sink 35 when they are brought together to form the cylindrical apertures. The first finned heat sink 33 and the second finned heat sink 35 are mechanically clamped together by the interlocking tabs 45 for ease of installation.

Referring to Figure 8b, when all of the required thermal transfer members/ heat pipes (not shown) are held in the desired position a locking pin 47 is inserted into the or each small gap between the tab 45 of the first finned heat sink 33 that is interlocked with the tab 45 of the second heat sink 35. In this final stage of installation, insertion of the locking pin 47 releases the mechanical clamp between the interlocking tabs 45 to transfer the locking force to the or each locking pin 47. The locking pin 47 is a tension pin or a spring pin. Referring to Figure 5b, in an alternative embodiment a screw 47' is inserted into the or each small gap between the tab (not shown) of the first finned heat sink 33 that is interlocked with the tab (not shown) of the second finned heat sink 35.

Referring to Figure 8b and Figure 7, insertion of a locking pin 47 in a direction parallel to the axis of the cylindrical recess 41 forces the tab 45 of the first finned heat sink 33 into locking engagement with the tab 45 of the second finned heat sink 35. Thus, each heat pipe 50 is held securely with the cylindrical recess 41 in the cooling module 31 so that the condenser section is held against the finned heat sinks 33, 35 for optimum thermal transfer of heat from the heat pipe 50 to the fins 39.

Referring to Figure 6, the evaporator section of each of the heat pipes 50 protrudes from the base of the cooling module 31 to be secured proximal to the LED heat sink in the lamphead.

Referring to Figure 8a, in a maintenance position without the locking pin inserted, the first and second finned heat sinks 33, 35 can move in a direction shown by arrow A towards and away from a thermal transfer member/heat pipe/s contained between them in the cylindrical recesses. Referring to Figure 7b, when the locking pin 47 is inserted, in a use position, the first and second finned heat sinks 33, 35 are forced towards each other in a direction shown by arrow B so that their internal surfaces are proximal to each other and are locked in position.

In use with an LED curing apparatus, a plurality of cooling modules are arranged along the length of the LED curing apparatus around a plurality of thermal transfer members, for example heat pipes or metal rods. The cooling modules have a length of about 25mm and are arranged substantially along the full length of the lamphead and are locked in place by the locking pins. For known devices, thermal transfer members, for example heat pipes or metal rods are spaced at increments of about 2.5cm for a range of lengths from 2.5cm to 250cm. The cooling modules are configured so that the cooling modules can be conveniently installed on site; for example, during an on-site repair. The cooling modules can be fixed to the thermal transfer members, for example heat pipes or metal rods after the LEDs are attached to the LED heat sink.

The lamphead comprises an array of LED modules (not shown), wherein each LED module is a unit containing one or more LEDs. In use, each LED is a radiation source for curing print or a coating on a substrate (not shown). It is understood that the LED modules form a linear radiation source to direct radiation continually onto a substrate during curing. The LED modules comprise boards that rest on a heat sink (not shown). This LED heat sink is adjacent to the evaporator section of each of the plurality of heat pipes or to one end of each of a plurality of metal rods.

In use, the LEDs are arranged to emit radiation from an outer, substrate-facing side through a "curing window" onto a substrate (not shown) to be cured. In alternative embodiments, the "curing window" comprises a lens or reflector. The lamphead is an elongate shape and can be fitted directly onto a machine, or is a slideable cuboidal cassette which, in use, is slideable into a housing. When inserted into the housing, the LED modules form a solid radiation emitting face.

Referring to Figures 5a and 6 in use, heat is transferred away from the inner face of the LED modules to the evaporator section of the heat pipes 50. Heat is carried from the evaporator section of each heat pipe 50 to the condenser section that is held substantially within the cooling module 31. In alternative embodiments, as shown in Figure 5b, heat is carried from a first end of a thermal transfer member, such as a metal rod to a second end of a thermal transfer member/metal rod within the cooling module 31. Heat is then efficiently transferred though the first and second finned heat sink 33, 35 so that the LEDs are rapidly and efficiently cooled. Furthermore, the configuration of the present invention ensures that the cooling modules 31 hold the thermal transfer members/heat pipes 50 in place, achieving good thermal contact between the finned heat sinks 33, 35 and the heat pipes 50, wherein the clamping force between the heat sinks 33, 35 and the heat pipes 50 is uniform along the length of the cooling module 31.

The heat pipes 50 of the present invention use known heat pipe technology to take up heat generated by the LED modules (not shown). In use, when the lamphead is switched on and the LEDs are radiating to cure a substrate, heat generated by the LEDs is transferred away from the rear, inner face of each LED module to an aluminium heat sink (not shown). Heat is carried away from the LEDs and the copper heat sink by the heat pipe/s 50 and is then carried away from the heat pipes 50 by the first and second finned heat sinks 33, 35. On heating, the liquid held within the core of the heat pipe 50 is vaporised and the heat is carried away before the liquid re-condenses and a wick transports the liquid back to the base of the heat pipe 50. Heat is rapidly transferred from the LED modules to the heat pipes 50 and to the cooling modules.

Referring to Figures 5a and 5b, to access the heat pipes 50 for maintenance or repair, the pins 47 or screws 47' securing the cooling module 31 around the heat pipes 50 or metal rods 50' are removed. With the pins 47 or screws 47' removed, the first finned heat sink 33 is able to move away from the second finned heat sink 35 increasing the size of the cylindrical recesses and allowing the cooling module 31 to be removed from the heat pipes 50 or metal rods 50'. Movement of the first finned heat sink 33 and second finned heat sink 35 away from each other causes the locking tabs 43, 45 to move into an interlocking position. This maintains the first finned heat sink 33 interlocked with the second finned heat sink 35 so that the components of the cooling module 31, 31' remain assembled when the cooling module is in a maintenance configuration. The cooling module 31, 31' can then be removed from the thermal transfer members; i.e., the heat pipes 50 shown in Figure 5a and the metal rods shown in Figure 5b, if required.

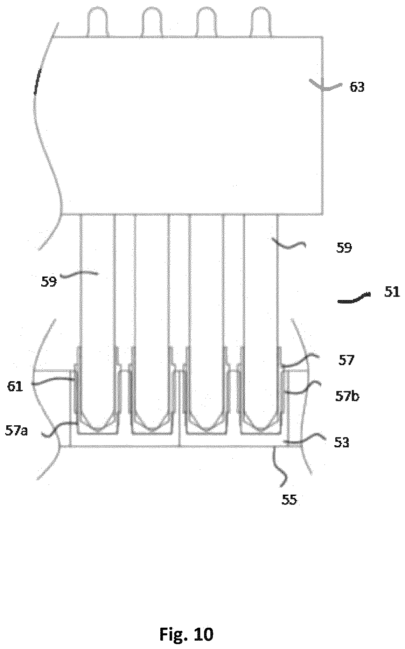

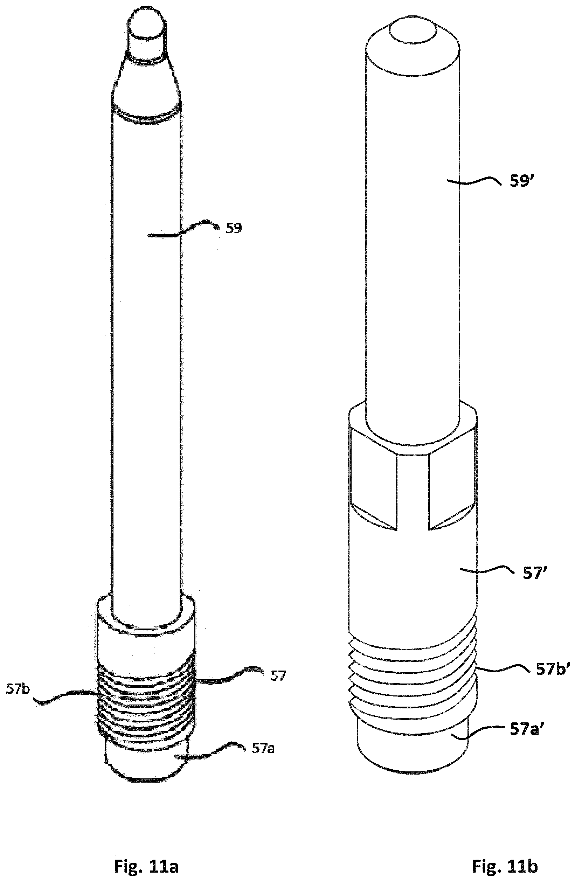

Referring to Figures 10 and 11, a cooling system 51 for an LED print curing apparatus is shown. The cooling system 51 comprises an LED mount 53. In use a plurality of LEDs 55 are mounted on the LED mount 53. In use, the LEDs are arranged to emit radiation from an outer, substrate-facing side. The cooling system 51 supports a plurality of copper heat pipes 59, wherein the heat pipes 59 sit within the body of the LED mount 53 and transfer heat away from the LEDs 55 to a cooling module 63. It is understood that in further embodiments, an alternative thermal transfer member rather than the heat pipe shown in Figures 10 and 11 is used; for example, a metal rod.

The cooling system 51 comprises an aluminium LED mount 53, which carries heat generated by the LEDs 55 away from the LEDs to the thermal transfer members/copper heat pipes 59. The dimensions of the aluminium LED mount 53 are carefully configured to be fitted within the lamphead of a curing apparatus (not shown). The cooling system 51 comprising the LED mount 53, LEDs 55 and thermal transfer members/heat pipes 59 form a modular system. In use, multiple cooling systems 51 are arranged along the length of a curing apparatus. The plurality of thermal transfer members/heat pipes 59 are a passive heat transfer system to efficiently carry heat away from the LEDs 55. In one embodiment of the present invention, the modular system comprises two heat pipes 59 per length of LED mount 53.

With reference to Figure 10, Figure 11a and 11b, each of the thermal transfer members/copper heat pipes 59', 59 are provided with a copper collar 57', 57, which is soldered to the heat pipe 59 or metal rod 59'. The collar 57, 57' includes a screw thread 57b, 57b' on a substantial portion of an outer surface thereof and a smooth, non-threaded portion 57a, 57a'. The LED mount 53 comprises a series of substantially cylindrical bores 61, which have a threaded inner surface for engagement with the corresponding screw thread on the outer surface of a copper collar 57, 57'. This allows the thermal transfer members/heat pipes 59', 59 to be screwed into the bores 61 in the LED mount 53 for secure attachment thereto with the collar 57, 57' surrounding the evaporator section of the heat pipe 59 or the first end of the thermal transfer member (metal rod) 59', so that each thermal transfer member/ heat pipe 59', 59 is fully contained within the LED mount 53 when fitted to the cooling system 51 . In alternative embodiments, such as shown in Figure 11b, using a metal rod 59' as a thermal transfer members, the collar 57' is soldered to a first end of the metal rod 59' and, as previously described, the metal rod 59' is screwed into the bores in the LED mount. As previously described, the LEDs can be mounted to the LED mount before the metal rods 59' are each fitted into a respective bore. In use, this allows the LEDs 55 to be mounted to the LED mount 53 before the metal rod 59' or heat pipes 59 are each fitted into a respective bore 61.

Referring to Figure 11b, the collar 57' and metal rod 59' are formed as a single piece. This improves thermal transfer and reduces the time and complexity of installation.

The configuration shown in Figures 10, 11a, 11b and 12 significantly improves the ease of installation of the thermal transfer members/heat pipes 59, 59' within a curing apparatus. In use, the LEDs 55 are attached to the LED mount 53 and the thermal transfer members/heat pipes 59', 59 are attached at a later stage. This minimises the installation time in a clean room because only the LEDs need to be installed in this controlled environment, whilst other components of the cooling system can be installed at the location of use of the apparatus. Multiple LED mounts 53 having LEDs 55 attached thereto are installed in the chassis of a curing apparatus before the thermal transfer members/heat pipes 59', 59 are screwed into the LED mount 53 and attached thereto by the mating engagement of the screw thread 57b, 57b' on the outer surface of the collar 57, 57' with the threaded inner surface of the bore 61 into which the thermal transfer member/heat pipe 59', 59 is received. The present invention allows for ease of assembly of the LED mounts 53 into the curing apparatus before the thermal transfer members/heat pipes 59', 59 and further cooling components are installed. Furthermore, the thermal transfer members/heat pipes 59', 59 and other cooling components can be removed and replaced; for example, if these components fail or require cleaning, without the sealed chassis of the apparatus containing the LEDS being removed. Removal of the LEDS is more likely to damage the delicate LEDs. The present invention significantly reduces the risk of damage or contamination of the LEDs.

A ceramic paste (not shown) is provided between the outer surface of each of the collars 57, 57' and the respective inner surface of the bore 61 in which the thermal transfer members/heat pipe 59', 59 is held. The ceramic paste prevents voids forming between the collar 57, 57' and the bore 61, which ensures optimum thermal contact between the LED mount 53 and the thermal transfer members/heat pipes 59', 59 because there are no thermal barriers to the heat transfer away from the LED mount 53 and so away from the LEDs 55, in use.

In the example shown in which corresponding screw threads 57b, 57b' are provided on the external surface of the collar 57, 57' and the internal surface of the bore 61, it will be appreciated that the ceramic paste can be applied to one or both threaded surfaces before the thermal transfer members/metal rods/ heat pipes 59', 59 are screwed into the LED mount 53. During installation, the rotation of the external threaded surface of the collar 57, 57' against the internal threaded surface of the bore 61 spreads the ceramic paste so that any voids are eliminated.

Referring to Figures 10 and 11a, in use, the central core of each heat pipe 59 contains a liquid, such as water or ammonia, which prior to heating is held by a wick structure (not shown). The heat pipe 59 contains a vacuum so that the liquid will boil and take up heat generated by the LEDs 55 at a temperature below the boiling point of the liquid at atmospheric pressure. The water will boil and effectively transfer latent heat from the LEDs 55 modules at this lower temperature. In use, when the LED print curing apparatus is switched on and the LEDs 55 are radiating to cure a substrate, heat generated by the LEDs 55 is transferred away from the rear, inner face of the LEDs 55 to the LED mount 53. Heat is carried away from the LED mount 53 by the heat pipe/s 59 to a cooling module 63. On heating, the liquid held within the core of the heat pipe 59 is vaporised and the heat is carried away before the liquid re-condenses and the wick transports the liquid back to the base of the heat pipe 59. The heat pipe/s 59 ensures that heat is carried away quickly and efficiently from the LEDs 55 and condensation of the liquid contained within the core of the heat pipe 59 is enhanced by capillary action.

As shown in Figure 10, the evaporator section of each heat pipe 59 is adjacent to the LED mount 53 and the LEDs 55 that are mounted thereon. The opposing end - i.e., the condenser end of each heat pipe 59 is held within a cooling module 63. In a preferred embodiment, the cooling module 63 is an air-cooled finned heat sink.

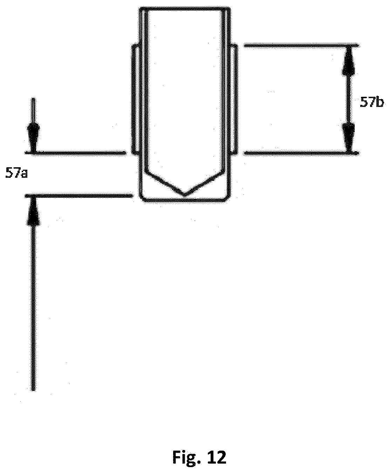

As shown with particular reference to Figures 11a, 11b and Figure 12, in order to increase the contact surface area of the collars 57, 57' and the bores 61, the outer walls of the collars 57, 57' are shaped to fit against correspondingly shaped walls of the bores 61. Each collar 57, 57' has a smooth, rounded base section 57a,57a' which is received into a bore 61. The mechanical fit of the threaded portion 57b, 57b' with the threaded portion of the bore 51 in addition to the heat transfer material (not shown) between the external surface of the collar 57, 57' and the thermal transfer member/metal rods/ heat pipe 59', 59 and the internal surface of the bore 61 ensures that there are no voids such that thermal transfer is optimised.

The above described embodiment has been given by way of example only, and the skilled reader will naturally appreciate that many variations could be made thereto without departing from the scope of the claims.

Within this specification embodiments have been described in a way which enables a clear and concise specification to be written, but it is intended and will be appreciated that embodiments may be variously combined or separated without parting from the invention. For example, it will be appreciated that all preferred features described herein are applicable to all aspects of the invention described herein and vice versa.

Within this specification, the term "about" means plus or minus 20%, more preferably, plus or minus 10%, even more preferably, plus or minus 5%, most preferably, plus or minus 2%.

Within this specification, the term "substantially" means a deviation of plus or minus 20%; more preferably, plus or minus 10%; even more preferably, plus or minus 5%, most preferably, plus or minus 2%. Within this specification, reference to "substantially" includes reference to "completely" and/or "exactly." That is, where the word substantially is included, it will be appreciated that this also includes reference to the particular sentence without the word substantially.

## Claims

1. An LED curing apparatus comprising:
at least one LED radiation source mounted on an LED mount;
a housing comprising at least one air inlet;
at least one finned heat sink; and
at least one air passage through the housing from the or each air inlet through the or each finned heat sink to at least one air outlet;
wherein the housing comprises an inlet cavity below the or each finned heat sink and an outlet cavity above the or each finned heat sink to maintain a higher air pressure below the or each finned heat sink and
a lower air pressure above the or each finned heat sink.

2. An LED curing apparatus according to claim 1 further comprising a source of air and wherein the air pressure in the inlet cavity below the or each finned heat sink is higher than the air pressure in the outlet cavity above the or each finned heat sink to cause suction of air along the or each air passage through the housing from the or each inlet to the or each air outlet through the or each finned heat sink

3. An LED curing apparatus according to claim 1 or claim 2 comprising a source of air wherein the air pressure decreases from the at least one air inlet to the inlet cavity and decreases further from the inlet cavity to the outlet cavity and decreases further again from the outlet cavity to the or each air outlet.

4. An LED curing apparatus according to any preceding claim comprising a plurality of LEDs in a linear array.

5. An LED curing apparatus according to any preceding claim wherein the or each air passage comprises at least one restriction below the or each finned heat sink.

6. An LED curing apparatus according to claim 5 wherein the restriction below the or each finned heat sink reduces the cross sectional area of the air flow path from the inlet cavity below the or each finned heat sink to the or each finned heat sink.

7. An LED curing apparatus according to any preceding claim wherein the reduction in the cross sectional area of the air flow path from the inlet cavity below the or each finned heat sink to the or each finned heat sink is by a ratio of between 1:2 to 1:3.

8. An LED curing apparatus according to any preceding claim wherein the reduction in the cross sectional area of the air flow path from the inlet cavity below the or each finned heat sink to the or each finned heat sink reduces by more than 50%.

9. An LED curing apparatus according to any preceding claim further comprising at least one source of air and at least one fan to move air into the or each air passage.

10. An LED curing apparatus according to any preceding further comprising at least one source of air and at least one fan to pull air into the or each air passage.

11. An LED curing apparatus according to any preceding further comprising at least one source of air and at least one fan positioned at a distance from the LED curing apparatus.

12. An LED curing apparatus according to any preceding claim wherein the at least one air outlet is at a first end of the apparatus and the opposing second end of the apparatus is sealed.

13. An LED curing apparatus according to any preceding claim wherein the or each air inlet is along substantially the entire length of the apparatus and/or wherein the at least one air inlet comprises an elongate opening and/or wherein the at least one air inlet comprises an opening in the upper face of the apparatus.

14. An LED curing apparatus according to any preceding claim wherein the outlet cavity has a greater cross-sectional area than the cross sectional area of the adjacent finned heat sink.

15. An LED curing apparatus according to any of claims 2 to 14 wherein:
i. the pressure difference between the inlet cavity and the outlet cavity exceeds between about 150Pa and 400Pa along the length of the LED curing apparatus; and/or
ii. wherein the air pressure in the inlet cavity below the or each finned heat sink is between about -310Pa and -610Pa relative to atmospheric pressure; and/or
iii. wherein the air pressure in the or each outlet cavity is between about -1150Pa and -650Pa relative to atmospheric pressure.
